(19)

Europäisches
Patentamt
European
Patent Office
Office européen
des brevets

(11) **EP 1 873 545 A2**

(12) **EUROPEAN PATENT APPLICATION**

(43) Date of publication:
**02.01.2008 Bulletin 2008/01**

(51) Int Cl.:
***G01R 33/28*** *(2006.01)*

(21) Application number: **07117771.1**

(22) Date of filing: **22.12.1999**

(84) Designated Contracting States:
**AT BE CH CY DE DK ES FI FR GB GR IE IT LI LU MC NL PT SE**

(30) Priority: **23.12.1998 US 113782 P**

(62) Document number(s) of the earlier application(s) in accordance with Art. 76 EPC:
**06075070.0 / 1 650 576**
**99967628.1 / 1 161 691**

(71) Applicant: **Jakab, Peter D.**
**Brookline, MA 02146 (US)**

(72) Inventor: **Jakab, Peter D.**
**Brookline, MA 02146 (US)**

(74) Representative: **Greene, Simon Kenneth**
**Elkington and Fife LLP**
**Prospect House**
**8 Pembroke Road**
**Sevenoaks,**
**Kent TN13 1XR (GB)**

Remarks:
This application was filed on 02 - 10 - 2007 as a divisional application to the application mentioned under INID code 62.

(54) **Magnetic resonance scanner with electromagnetic position and orientation tracking device**

(57) A system for combining electromagnetic position and orientation tracking with magnetic resonance scanner is provided. The position and orientation of a magnetic field sensor is determined by a position and orientation tracking device using a model of the magnetic field generation which accounts for the presence of the magnetic resonance scanner.

POSITION AND ORIENTATION TRACKING DEVICE

MAGNETIC FIELD SOURCE 210     MAGNETIC FIELD SENSOR 220

PROCESSOR FOR POSITION AND ORIENTATION TRACKING 292

POSITION AND ORIENTATION TRACKING DEVICE 200

FIG. 2A

EP 1 873 545 A2

## Description

## TECHNICAL FIELD

The present invention relates to magnetic resonance and position tracking and, more specifically, to the combination of a magnetic resonance scanner with an electromagnetic position and orientation tracking device for tracking a position and orientation of an object.

## BACKGROUND OF THE INVENTION

United States Patent 4,737,794 presents a method and apparatus for determining the position of a remote object and its orientation relative to a reference object by measuring the electromagnetic couplings between field generating and sensing elements embedded in reference and remote objects. The apparatus measures the couplings between the fields of the reference and remote object with the generation of a plurality of alternating current (AC) signals applied to the field generating elements and with the measurements of the coupled signals of the sensing elements. The method utilizes a model having an approximation of the dipole magnetic field of the generating source, based on Legendre polynomials, and computes the coupling between the generating and sensing element starting from an estimated value for the remote object position and orientation. An error is computed between the measured couplings and the one computed from the estimated position and orientation. The error is then used in conjunction with the estimated position and orientation until there is a convergence which produces a position and orientation representative of the actual position of the remote object. When the physical dimensions of the generating and sensing elements are comparable to the separation between them, the model fails. The model also has no means to compensate for field distorting elements, for example, the presence of conductive or ferro-magnetic material. United States Patent 4,849,692 further extends the method to utilize pulsed direct current (DC) magnetic fields in place of AC fields, but has the same limitations.

United States Patent 5,558,091 and 5,600,330 describes an apparatus which utilizes a triad of Helmholtz coil pairs for the generation of magnetic fields. The method used by the apparatus for calculating the position and orientation of a group of magnetic field sensors uses linear or quasi-linear approximation of such Helmholtz source coils. Because the magnetic field sensor must be within the quasi-linear section of the magnetic field of the Helmholtz coils, large coils are required for position and orientation tracking over the required area, therefore the presence of the magnetic resonance scanner will interfere with the operation of the position and orientation tracking device. As a result, in prior art optical methods are preferred.

United States Patents 5,617,857, 5,622,170 and 5,828,770 describes the use of optical tracking devices for object position and orientation tracking. These optical devices require a line of sight between the optical camera and the position-sensing device, which limits the use of these devices.

WO96/05768 describes a system for determining the position and orientation of an invasive medical instruments using a plurality of magnetic field radiators and a plurality of sensors. The field generators preferably generate a continuous AC magnetic fields, a plurality of sensors situated in the invasive medical instrument which generate sensor signals in response to said fields. A signal processor which has an input for a plurality of signals corresponding to said drive signals and said sensor signals and which produces the three position coordinates and three orientation coordinates of a point on the invasive medical instrument is derived from field equations which are dependent on the geometry and characteristics of the radiators. In the preferred embodiment the radiators are coils, the field equations also described utilizing Legendre Polynomial of degree n.

United States Patent 5,211,165 describes a tracking system using radio frequency signals emitted by a small coil attached to an invasive device. This small coil is driven by a low power RF source and creates a dipole electromagnetic field. This dipole field induces currents and voltages in an array of receive coils distributed around a region of interest. The receive coils are designed to have sensitivity characteristics that vary linearly with position. These voltage signals from the receive coils are digitized and sent to a tracking computer for analysis. The tracking computer utilizes linear methods to solve for the position and orientation of the transmit coil.

United States Patent 5,600,330 teaches a device where the electromagnetic transmitting antennae is driven either DC or AC signal, and a processing means to determine position and orientation from the resultant non-dipole fields. To calculate the position of the receiving antennae comprises the steps of initializing the geometry of the transmitting antennae by defining the x, y, z coordinates of ends of each antenna segment; measuring the induction field components from the transmitting antennae; computing the magnitudes of the measured induction vectors; representing the magnitudes and angles of the measured magnetic field as a linear extrapolation from a computed value by using a first order Taylor expansion about the computed value; computing the partial derivatives of the Taylor expansion, and solving for dX, dY and dZ; and iterating the values of dX, dY and dZ until values are sufficiently small to give accurate indication of the coordinates of the receiver in the x, y, z coordinate plane defined by the transmitting antennae. The transmitting antennae may be represented as an N sided polygon where N=4 given as an illustrative example.

Devices built on the teaching of US 4,737,794 and US 4,849,692 do have a built error correction as such utilized in US 5,787,886, which describes a device and method, which is known as a "frameless" stereotaxis system, and uses coordinate referencing between the CT or MRI scans and a stereotaxic referencing system which uses an electromagnetically driven system to determine the location of a stereotactic frame by taking calibration measurements. It utilizes an error value which is calculated from the location calculated by the electromagnetically driven system and the correct location calculated by other means than the electromagnetically driven system. This location correction is then applied to the location of the stylus after having calculated the location based on the model of generation of magnetic field in the electromagnetically driven system.

United States Patent 5,752,513 teaches an apparatus for determining the position of a probe in a sensing volume includes a plurality of magnetic filed generating sources for generating different magnetic fields in the sensing volume, where the sources have a planar configuration and are positioned so that they at least partially overlap one another in horizontal extent and so that the sensing volume extends outwardly from the sources. The probe is provided with sensors which detect magnetic field components of fields generated by the sources. The position of the probe can be determined from the detected magnetic field components. The magnetic field generating sources are preferably formed from a plurality of conductor segments, and the calculation means calculates the magnetic field B of each conductor segment in accordance with equation $|B(x,y,z)| = I(\cos(A1)+\cos(A2))/(cR)$ where I is the current through the conductor segment, c is the speed of light, R is the distance between the position of the sensor at point at $r=(x,y,z)$ and the conductor segment, A1 is the angle between the sensor and one end of the conductor segment, and A2 is the angle between the sensor and the other end of the conductor segment. In terms of shape, the conductor segments of each source are preferably polygonal in shape, and more desirably comprise isosceles triangles. Three sources or more preferably four sources are employed by this prior art. One position determining method that utilized to determine the position of the probe sensing the magnetic field components generated by the coils involves solving an overdetermined system of equations, using a standard nonlinear least squares minimization algorithm, such as the Gauss algorithm or the Levenberg-Marquardt algorithm, known by those skilled in the art. Starting from an initial guess, these algorithms iteratively improve on the guess by a well-known and well-defined procedure. In the preferred embodiment using four coils, there would be twelve nonlinear equations with six unknowns. The unknown variables include the position vector of the probe, and its orientation parameterized as roll, pitch and yaw angles.

United States Patent 5,592,939 teaches a system for navigating a catheter probe through a body cavity. It includes a sensing coil affixed to a distal end of the probe. Magnetic fields are projected into the body cavity to induce voltage signals in the sensing coil that are sufficient to describe the orientation and position of the probe. A set of magnetic coils each generates a substantially uniform field in a single respective dimension. The orientation angles of the sensing coil may be determined from known values of the unidirectional fields and the measured induced voltage signals. Gradient magnetic fields with components in two dimensions are projected into the body cavity to induce another group of voltage signals. The geometrical intersection of constant voltage surfaces developed by certain gradient fields that produce the measured induced voltage signals is a set of lines on which the catheter is located. The point of intersection of such lines yields the positional coordinates. A series of soluble mathematical expressions describing the position and orientation of the sensing coil. The mathematical construct underlying this prior art is a methodology termed separation of variables. In accordance with this methodology, appropriate equations are developed to isolate unknown variables in such a manner that renders the equations uniquely soluble. There are five unknown variables that define the position and orientation of the sensing coil. A typical approach to solving for these variables would be to develop a series of coupled non-linear equations expressing the relationship among the variables. However, these equations are generally not uniquely soluble, i.e., multiple solutions are possible. The mathematical approach used herein and predicated on the separation of variables concept is directed to the development of a series of signal expression statements functionally relating induced voltage values to certain ones of the unknown position parameters. The relationships defined by these expression statements are such that the unknown variables are determinable by sequentially solving the expression statements. In accordance with one aspect of this prior art, a class of special magnetic fields is generated with characteristic spatial structuring and shaping that is sufficient to cause the variables to separate within these induced voltage equations so as to permit resolution of the parameters when the equations are sequentially solved.

United States Patent 5,307,808, 5,353,795, 5,715,822 and X. MA, et. al., in Proc. of the ISMRM, 1998, p. 688 each demonstrate methods for calculating the position and orientation of an RF coil, where the position of a small RF coil is computed from the magnetic resonance signal emanated from a subject surrounding the coil itself in the presence of spatially encoded magnetic field gradients. The apparatus uses the frequency of the magnetic resonance signal to determine the RF coil location for a spatial dimension. In this apparatus, a magnetic resonance scanner generates a quasi-linear magnetic field gradient via the gradient coils of the magnetic resonance scanner. Because the frequency of the magnetic resonance of the material surrounding the RF coil is proportional to the strength of the magnetic field, the distance of the RF coil from the center of the gradient coil of the magnetic resonance scanner is assumed to be proportional, providing the location of the RF coil. The model for the magnetic field source is based upon a linear approximation and does not account for magnetic field gradient deviations which occur in magnetic resonance scanners, which results in inaccuracy. Additionally, when there is no material surrounding the RF coil, the device fails, since either a weak magnetic resonance signal or no magnetic resonance signal is produced. As a result, the use of such a device is limited by these constraints.

J. Andrew Derbyshire, et. al., in JMRI 8 (1998) 924-932 investigates an alternative approach for automatically updating the imaging scan plane, compensating for subject motion, and thereby providing registered images that track a prescribed region of interest from the subject. The technique uses established MR methods to monitor the positions of multiple fiducial marker devices that are fixed to the subject. The approach relies on that the size of the homogeneous region is large enough to encompass the subject and multiple fiducial markers. Then the subject motion can be tracked via scanning the subject and tracking the location of the fiducial markers.

EP 512,345 describes a method and apparatus for performing high speed, high resolution nuclear magnetic resonance imaging wherein the magnetic coils for inducing the desired magnetic fields and the magnetic coils for receiving the magnetic field caused by NMR are positioned to one side of the volume under observation. Disclosed coil configurations provide a relatively large volume homogenous Ho field and three orthogonal gradient fields, so as to create a relatively large volume of observation which is broken up into high resolution voxels by appropriate selection of each of the gradient fields. The voxel is shifted in space at time intervals by scaling one or more of the gradient fields at such time intervals. This prior art pertains to a method and apparatus for magnetic resonance imaging where the placement of the coils for generating the required magnetic fields is restricted. More particularly, this prior art pertains to a method and apparatus for inducing nuclear magnetic resonance in a geological formation and producing a high resolution image of the geological formation.

## SUMMARY OF THE INVENTION

Systems and methods for determining the position and orientation of an object with an attached sensor in a magnetic resonance scanner are disclosed. In general magnetic resonance scanners acquire data about a target or subject which resides within a homogenous region of a static magnetic field of the magnetic resonance scanner. In one embodiment of the invention, a magnetic resonance scanner is used in conjunction with an electromagnetic position and orientation tracking device to calculate the position and orientation of the object within the magnetic resonance scanner and may be used to track the object and the subject relative to a reference coordinate frame. In this embodiment, magnetic fields are used for position and orientation tracking of an object in order to avoid line of sight limitations.

A magnetic field is generated by a magnetic field source by applying electric current to a conductive wire loop of the magnetic field source. The generated magnetic field is sensed by a magnetic field sensor, allowing the tracking of the position and orientation of the object throughout the field of the magnetic field source. At the magnetic field sensor, an electric signal is measured which is proportional to the magnetic field. Using the measured value of the electric signal from the magnetic field sensor, a measured magnetic field may be calculated by a model of magnetic field sensing. Using a model of the magnetic field generation of the magnetic field source, at an estimated position and orientation given in the reference coordinate frame, an estimated magnetic field can be calculated. Comparing the estimated magnetic field to the measured magnetic field, an error can be computed. The estimated position and orientation for the magnetic field sensor is then changed and the steps repeated until the error between the estimated magnetic field and the measured magnetic field falls below an acceptable level. When the error falls below the acceptable level, the position and orientation of the sensor based on the estimated position and orientation provides a representation of the actual position and orientation.

The magnetic field generation model used in this system includes a line segment approximation of the shape of the magnetic field source and additional line segments accounting for field distorting components. This model compensates for distortions in the estimated magnetic field at the sensor by accounting for the magnetic field generated by the gradient coils of the magnetic resonance scanner and for the fields generated by any surrounding conductive and ferro-magnetic materials. The position and orientation and direction of the line segments is determined through test measurements of the currents in the gradient coils and the resulting magnetic field. The Biot-Savart Law is used in the magnetic field generation model to calculate the magnetic field generated by every line segment.

For the magnetic field sensing model, Faraday's Induction Law is used to calculate the electric signal induced into a solenoid type coil. Models for other type of magnetic field sensors can be used in place of Faraday's Induction Law for solenoid type coils where the magnetic field sensing model is derived based upon the physical law of operation for the sensor.

In one embodiment, an autonomous magnetic field source is mechanically coupled to the magnetic resonance scanner. In the preferred embodiment the magnetic field gradient generating coils of the magnetic resonance scanner generate the magnetic fields for position and orientation tracking.

When an object is attached to the magnetic field sensor, such as a pointer, the position and orientation of the pointer which is known by the position and orientation tracking device in the reference coordinate frame of the magnetic resonance scanner can be represented in combination with the acquired data from the magnetic resonance scanner.

**BRIEF DESCRIPTION OF THE DRAWINGS**

The foregoing features of the invention will be more readily understood by reference to the following detailed description taken with the accompanying drawings:

> Fig. 1A. depicts a system for magnetic resonance imaging of a subject with position and orientation tracking of an object.
> Fig. 1B is a block diagram showing the data and signal connections between the magnetic resonance scanner and the electromagnetic position and orientation tracking device.
> Fig. 2A. depicts an electromagnetic position and orientation tracking system having a magnetic field source, a magnetic field sensor and a processor for position and orientation tracking.
> Fig. 2B is a functional block diagram showing the functions which are performed within the position and orientation tracking processor and the data acquisition processor of Fig. 2A.
> Figs. 3A-3H show examples of the shape of a coil and the line segment representation approximating a finite-element representation of the coil in for modeling the magnetic field source.
> Figs. 4A-D show examples of magnetic field sensing coils.

**DETAILED DESCRIPTION OF EMBODIMENTS OF THE INVENTION**

The terms "location" and "position and orientation" will be used interchangeably in the following detailed description and appended claims and shall mean the position of an object, the orientation of an object or both the position and the orientation of an object where one or more degrees of freedom of the object, up to six degrees of freedom in three dimensional space is determined relative to a reference coordinate frame.

The term "coil" in the following description and accompanying claims shall mean a winding or loop of conductive material such as a copper magnet wire through which an electric current can flow. The term "loop" is used in an electrical engineering context referring to a complete circuit for current and does not imply that the shape is necessarily circular.

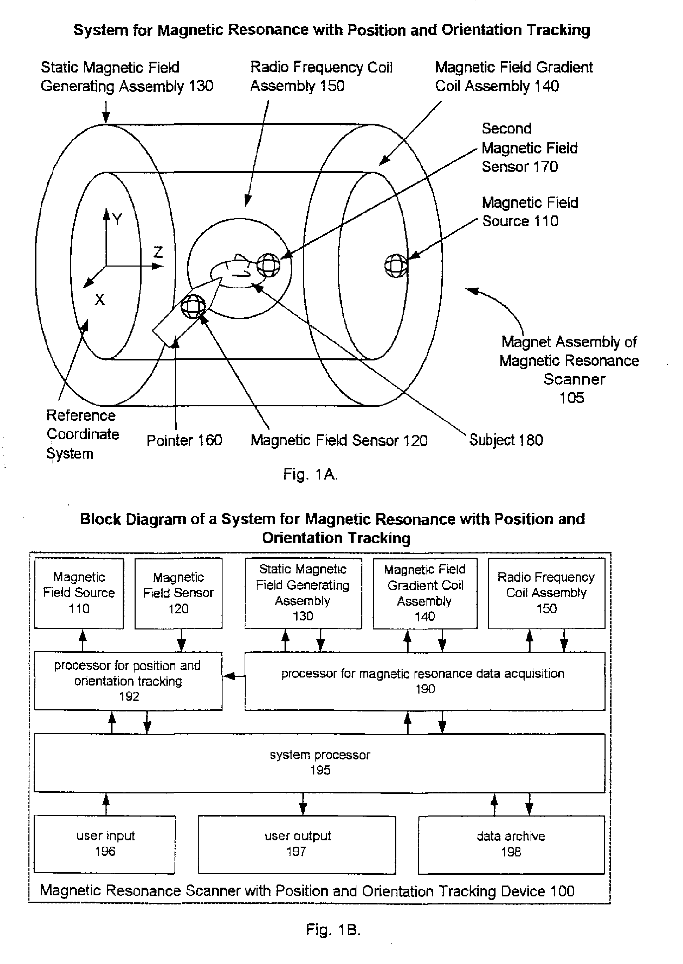

The present invention as embodied in Fig. 1A relates to tracking an object's position and orientation relative to a magnetic resonance scanner utilizing electromagnetic fields. Using electromagnetic fields which are independent of magnetic resonance, allows the object being tracked to be either internal or external to the subject. In this embodiment the electromagnetic fields are compatible with the magnetic resonance. The term compatible is used herein to mean that the normal operation of the magnetic resonance scanner is maintained with acceptable levels of artifacts.

A magnetic resonance scanner, in the preferred embodiment of the invention, is capable acquiring data for a visual representation of the spatial distributions of the nuclear spins of a subject. The magnetic resonance scanner runs a magnetic resonance sequence which generates spatial field gradients and corresponding radio frequency signals. An example of a magnetic resonance sequence is a coordinated sequence of events which include superimposing magnetic field gradients over the static magnetic field, generating radio frequency magnetic fields, detection of radio frequency magnetic fields and acquiring the magnetic resonance signal. A visual image corresponding to the induced magnetic resonance signal may be produced which represents the subject. Further description of the physics of a magnetic resonance is provided in Principles of Magnetic Resonance, Third Edition, ISBN: 0-387-08476-2, by C.P. Slichter, Springler-Verlag, NY, and Foundations of Medical Imaging ISBN: 0-471-54573-2, by Zang-Hee Cho et. al., Wiley & Sons N.Y., section III, chapters 9-13, page 236-454.

Magnetic resonance scanners are generally configured to a coordinate system to describe human anatomy wherein the coordinate system may be oriented about the potential data acquisition region of a subject. In the embodiment of this invention shown in Fig. 1A a reference coordinate system is established on the coordinate system of the magnetic resonance scanner. The reference coordinate system may follow the convention of general practice as shown by the axes designated X, Y, and Z. It should be understood by one of ordinary skill in the art that such a reference coordinate system may be repositioned or reoriented relative to the coordinate system of the magnetic resonance scanner or to any object for which the object's position and orientation is established.

Fig. 1A depicts a system 100 for magnetic resonance imaging of a subject with position and orientation tracking of an object. The system 100 includes a magnetic resonance scanner with a coupled electromagnetic position and orientation tracking system having a magnetic field source 110 and a magnetic field sensor 120 coupled to a magnet assembly 105 of a magnetic resonance scanner. The magnetic resonance scanner in its magnet assembly 105 includes a static magnetic field generating assembly 130, a magnetic field gradient coil assembly (gradient coils) 140, which is usually a set of three coils, and Radio Frequency (RF) coil assembly 150. The position and orientation tracking device includes a magnetic field source 110, secured to the magnet assembly of the magnetic resonance scanner and at least one magnetic field sensor 120 for tracking an object's position and orientation, such as a pointer 160. The magnetic resonance scanner also includes a processor 190 for data acquisition of the magnetic resonance spectroscopy or imaging sequence and may include an additional processor for handling user input and output and data processing and task coordination 195.

In a preferred embodiment, the position and orientation tracking device utilizes the gradient coil set of the magnetic resonance scanner for the generation of magnetic fields for position and orientation tracking. During a magnetic resonance sequence, for example, a multi-slice 2-D or a 3-D sequence, the three gradient coils of the magnetic resonance scanner generate timely and spatially varying magnetic fields. Golay type coils are generally the shape used for two of the three gradient coils in commonly used magnetic resonance scanners. The third coil is generally a Helmholtz type coil. It should be understood by those of ordinary skill in the art that other shaped coils may be used for the gradient coils of a magnetic resonance scanner. Various examples in this application use Golay or other shaped coils for magnetic field gradient generation, however this should in no way be seen as a limitation.

In the preferred embodiment, the magnetic field of the gradient coils are sensed by three small solenoid type coils having their axes perpendicular to each other. Other types of magnetic field sensors may be employed such as Hall effect, flux gate, Kerr-effect devices, SQUID devices or other sensing devices for which their magnetic field sensing is mathematically described in terms of physical principles.

In addition to the first magnetic field sensor, the position and orientation tracking device may include an additional magnetic field sensor 170 for tracking the position and orientation of a subject 180.

Fig. 1B is a block diagram showing the data and signal connections between the magnetic resonance scanner and the electromagnetic position and orientation tracking device. In a magnetic resonance scanner, the presence of the static magnetic field creates a magnetization of the nuclear spins of the subject. The processor for magnetic resonance data acquisition 190 supervises the static magnetic field generating assembly 130 through built in sensors. The processor 190 is also responsible for transmitting radio frequency signals to excite the nuclear spins of the subject and to receive the radio frequency signals in response of the transmission via the radio frequency coil assembly 150. To provide three dimensional spatial encoding of the nuclear spins present in the subject, the processor 190 also generates time and spatial variation in the static magnetic field through magnetic field gradient generating coils 140.

For example, the gradient coil 140 of the magnetic resonance scanner magnet assembly 105 generates a linear magnetic field gradient across the subject 180 encoding the nuclear spins in the subject 180 according to a magnetic resonance sequence, such that, the frequency of the magnetic resonance is linearly dependent on the position of the nuclear spins relative to the center of the gradient coil 140. Then a Fourier transform is performed in processor 190 to retrieve the position dependent spin density data from the acquired radio frequency signal and the resulting data is made available to the system processor 195. The system processor 195 is responsible for accepting the resulting data from processor 190, user input 196, for determining parameters of the data acquisition, and for presenting the resulting data to the user 197. The processor 195 may combine data from previous data acquisitions archived in a data archive 198 to help the user control the data acquisition and analyze the data presented.

The invention in the current embodiment also includes a position and orientation tracking device. The processor of the position and orientation tracking device 192 is responsible for generating a spatially unique magnetic field via a magnetic field source 110 and sensing the magnetic field via magnetic field sensor 120.

In the preferred embodiment, the magnetic field gradients generated by the magnetic field gradient generating coils 140 of the magnetic resonance scanner magnet assembly 105 are utilized as the source of the position and orientation tracking magnetic fields. Therefore, the processor for position and orientation tracking 192 receives a signal proportional to the current in the gradient coils 140 of the magnetic resonance scanner instead of generating the magnetic fields through a separate magnetic field source. The generated magnetic field of the gradient coils 140 induce a signal in the magnetic field sensor 120. The processor 192 then can calculate the position and orientation of the magnetic field sensor 120 utilizing this signal. The position and orientation tracking processor 192 is in communication with the system processor 195. The system processor 195 sets the parameters of the magnetic resonance data acquisition sequence through the user input, such as location of the scan, orientation of the scan, field of view, slice thickness, number of slices, or $T_1$ or $T_2$ weighting, for example. The system processor 195 instructs the processor for magnetic resonance data acquisition 190 to execute the magnetic resonance sequence with the required parameters to acquire magnetic resonance signals. While the sequence is running, the position and orientation tracking processor 192 also acquires signals for position and orientation tracking.

At the end of the sequence, the magnetic resonance data acquisition processor 190 and the processor for position and orientation tracking 192 will provide new data to the system processor 195. The system processor combines this data with previously acquired data from the data archive 198, to present to the user at the user output 197 a combined view of the subject, at the present and past times, and the position and orientation of the object 160, having an attached magnetic field sensor 120.

In the foregoing description, three processors were described, a system processor, a magnetic resonance data acquisition processor and a position and orientation tracking device processor. It should be understood by one of ordinary skill in the art that the functionality of the described processors may be combined into a single processor located in the magnetic resonance scanner or in the position and orientation tracking device or the functionality may be separated into additional processors in either the magnetic resonance scanner or the position and orientation tracking device. At a minimum, the system including the position and orientation tracking device and the magnetic resonance scanner must have a single processor. The number of processors within the system should in no way be seen as a limitation.

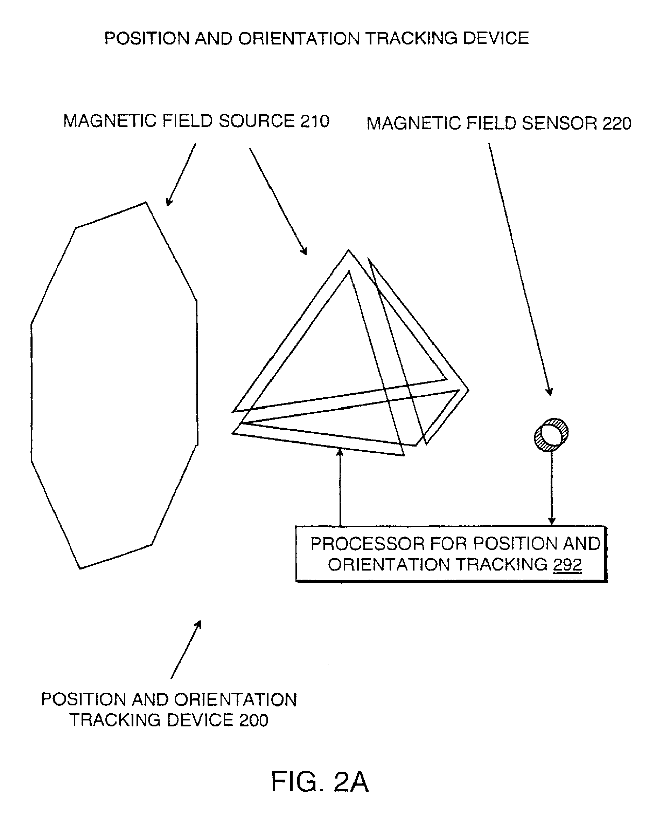

Fig. 2A depicts an electromagnetic position and orientation tracking system having a magnetic field source 210, a magnetic field sensor 220 and a processor for position and orientation tracking 292. The magnetic field source also includes elements which are not directly driven by the processor 292, but are magnetically coupled and these elements can distort the generated magnetic field. In the embodiment as shown in Fig. 2A, the magnetic field source is a tetrahedron. In such a three dimensional shape, the coil's axes are not orthogonal, and the generated magnetic field of each coil is mutually distinguishable and provides the means to obtain the maximum number of degrees of freedom for the magnetic field sensor. In the embodiment, the tetrahedron is composed of 3 triangular shaped coils. A triangular shaped coil provides the minimum number of linear elements that can be used to create a closed loop coil. Additionally, the tetrahedron shape is also preferred as it eliminates ambiguity in the determination of the position and orientation of the magnetic field sensor in certain situations. For example, a coil may be reoriented to a new position and orientation in such a manner that the polarity of the generated magnetic field changes to the opposing polarity while the intensity map of the generated magnetic field remains the same. Applying the same movement to the entire magnetic field source assembly, in which the polarity of the generated magnetic field changes to the opposing polarity for one coil while its magnetic field intensity map remains the same, the magnetic field intensity map of the other two coils will change from their original magnetic field intensity map. This provides a means for distinguishing between the two orientations of the magnetic field assembly. If symmetry existed between the normal and reverse intensity map due to the shape of the magnetic field source assembly, reversing the direction of the magnetic field source assembly and the magnetic field sensor would create ambiguity as to the position and orientation of the magnetic field sensor. Further, the tetrahedron shape allows for a fourth coil which can provide redundancy to the position and orientation tracking device creating further asymmetry to avoid ambiguity.

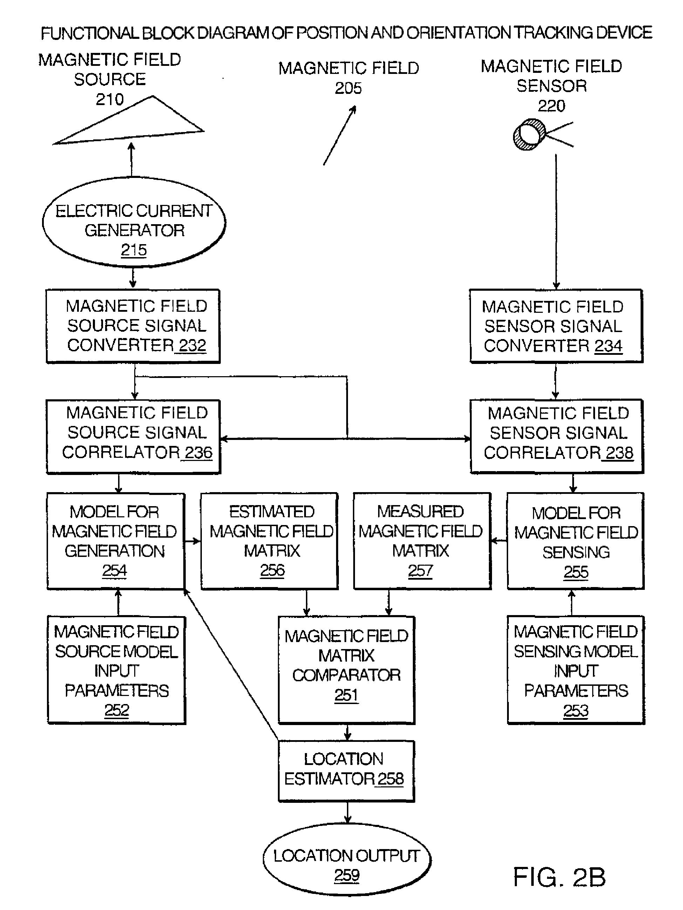

Fig. 2B is a functional block diagram showing the functions which are performed within the position and orientation tracking processor and the data acquisition processor of Fig. 2A. The process starts with the generation of an electric current by an electric current generator 215 through the magnetic field source 210. The magnetic field sensor 220 senses the magnetic field 205 of the magnetic field source 210 outputting an electric signal in response and proportional to the magnetic field 205 of the source 210. The current in the magnetic field source 210 and the signal which is measured by the magnetic field sensor 220 is converted from an analog representation to a digital representation to enable further processing to be performed in the digital domain. The electric current of the magnetic field source 210 is converted into a digital format by the magnetic field signal source converter 232. The signal output of the magnetic field sensor 220 is digitized by a magnetic field sensor signal converter 234. A magnetic field source signal correlator 236 then can calculate the auto-correlation function of the measured current of the magnetic field source. A magnetic field sensor signal correlator 238 calculates a cross-correlation function between the measured current of the magnetic field source and the measured signal of the magnetic field sensor. This process rejects the time variation of the signals and extracts from the measured signal of the magnetic field sensor the position and orientation dependency of the magnetic field sensor.

To perform various signal processing as previously discussed in an analog or digital domain, such as amplification, filtering, analog to digital conversion, digital to analog conversion, computing an integral of a function, computing cross-correlation between two functions, auto-correlation of a function, and finding minima of a function, standard engineering practices are used, such practices are described in The Electrical Engineering Handbook, Editor-in-Chief R.C. Dorf, CRC Press, FL, Signals and Systems, ISBN: 0-13-809731-3, by A.V. Oppenheim and A Willsky with I.T Young, Prentice-Hall, Digital Signal Processing by A.V Oppenheim and R.W Schafer, Prentice-Hall, Discrete-Time Signal Processing, by A.V. Oppenheim and R.W. Schafer, Prentice-Hall, NJ. Numerical Recipes in C, ISBN: 0-521-43108-5, W.H. Press, S.A. Teukolsky, W.T. Vetterling, B.P. Flannery, Cambridge University Press, MA, and Handbook for Digital Signal Processing, ISBN: 0-471-61955-7, edited by S.K. Mitra and J.F. Kaiser, John Wiley an Sons, NY.

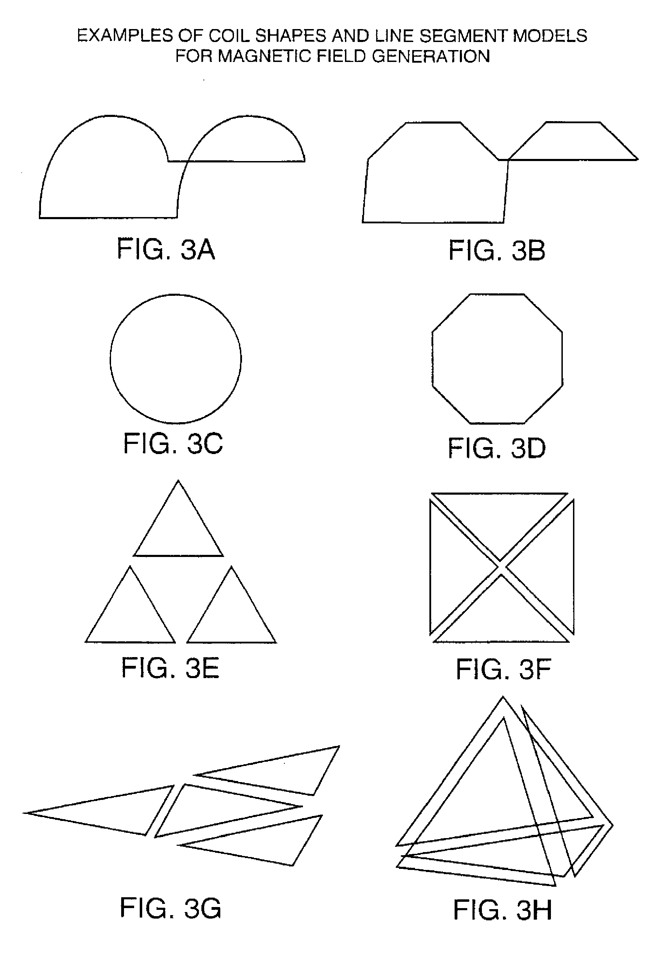

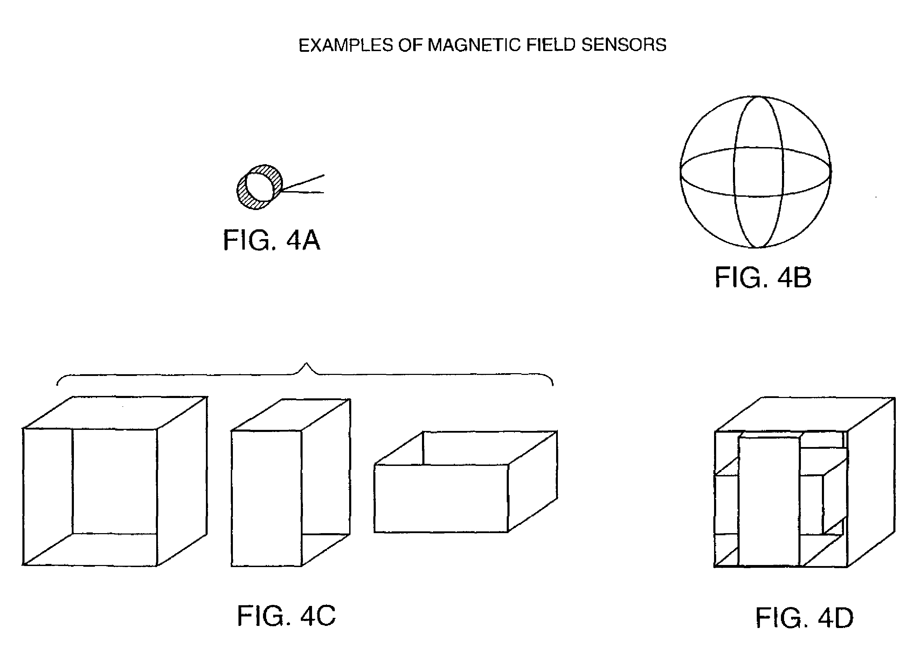

The magnetic field generation model as described below with respect to Figs. 3A-H is used to calculate the estimated magnetic field matrix 256 based on a position and orientation estimate 258, input parameters 252 of the magnetic field generation model, and the output of the magnetic field source signal correlator 236. The measured magnetic field matrix 257 is calculated by the magnetic field sensing model 255 as described with respect to Figs. 4A-D below based on the input parameters of the model of magnetic field sensing 253 and the output of the magnetic field sensor signal correlator 238. The measured and the estimated magnetic field matrixes 256, 257 are compared by a field matrix comparator 251 which produces an error value for the position and orientation estimator 258. The model for the magnetic field is initialized with an estimated position and orientation for the magnetic field source. This value may be manually set or may default to a position within the magnetic resonance scanner. For instance, the center of the magnetic resonance scanner could be the estimated position and orientation of the magnetic field sensor. It should be understood by one skilled in the art that the magnetic resonance scanner has an associated reference coordinate system wherein the origin of such a system may be configured to a point within or exterior to the magnetic resonance scanner. For example the origin of the system may be at the physical center of the magnetic resonance scanner.

The position and orientation estimator 258 generates a new estimate of the position and orientation of the magnetic field sensor until the error generated by the magnetic field matrix comparator 251 is below a given threshold. When this threshold is reached, the estimated position and orientation of the magnetic field sensor is an acceptable approximation of the real position and orientation of the magnetic field sensor 220. The position and orientation estimator determines the position and orientation through a minima finding algorithm. Once the position and orientation is determined it is then output. From output 259 the position and orientation of the magnetic field sensor may be displayed on a monitor (not shown), printed or stored in an associated memory position and orientation.

To determine the six unknowns for a six degree of freedom position and orientation tracking device at least six independent magnetic field measurements are required. Utilizing three gradient coils of the magnetic resonance scanner and at least two, but preferably three solenoid coils, nine independent measurements are possible. A Cartesian decomposition of the measurements of the magnetic field results in the measured magnetic field matrix 256. Accordingly, the estimated magnetic field matrix 257 will be equal in size to the measured magnetic field matrix 256. Creation of the measured magnetic field matrix 256 is described below with respect to Figs. 3A - H and the creation of the estimated magnetic field matrix is described below with respect to Figs. 4A - D.

Fig. 3A shows an example of the shape of a coil which is a Golay coil and Fig. 3B shows the line segment representation approximating a finite-element representation of the Golay coil, included in one model of the magnetic field source. The combination of the line segment representation in conjunction with the means for calculating the magnetic field at any position and orientation provides a sufficient description of the model of the magnetic field generation. The means for calculating the magnetic field is provided by a computer processor operating with computer code to calculate the Biot-Savart Law. The Biot-Savart Law expresses the relationship between the magnetic flux density generated by one piece of current carrying wire segment at a given position and orientation. For a wire element of $d\bar{l}$ the magnetic flux density $d\bar{B}$ is:

$$d\bar{B} = \frac{\mu_0 I}{4\pi} \frac{d\bar{l} \times \bar{r}}{r^3}$$

Where $\mu_0$ is the magnetic permeability of free space, $I$ is the intensity of the electric current in the wire, $\bar{r}$ is the vector pointing from the wire element to the position and orientation of the magnetic field being calculated. A more complete explanation of the Biot-Savart law is provided in Classical Electrodynamics Second Edition ISBN: 0-471-43132-X, by J.D. Jackson, Wiley & Sons N.Y., chapter 5, 168-208. To compute the estimated magnetic field at an estimated position and orientation of the magnetic field sensor, the sum of $d\bar{B}$ for each wire element over the entire length of the magnetic field model is calculated, utilizing the measured value of the current flowing into the gradient coils. Using the model as described above for each element of the magnetic field source given the current in the element, the estimated magnetic field at the estimated position and orientation of each element of the magnetic field sensor is calculated. The resulting values for the estimated magnetic field forms a matrix better described as the estimated magnetic field matrix.

Fig. 3C shows a ring and Fig. 3D shows the line segment representation of the ring of Fig. 3C. The ring of Fig. 3C or any other shaped coil is added to the model of the magnetic field generation to describe field distortions produced by conductive and ferro-magnetic material present in the magnetic resonance scanner other than the gradient coils. The position and orientation and direction of all the line segments present in the model are determined through test measurements of the currents in the gradient coils and the resulting magnetic fields.

Figs. 3E-H show structures with triangular shapes which can be used to represent the magnetic field source. Such structures may be added to an already existing magnetic resonance scanner. In the preferred embodiment, the gradient coils are used as the magnetic field source. As explained above, a triangular coil provides the simplest structure which has a match between an actual coil shape and a line segment representation. It should be clear to one of ordinary skill in the art that other line segment shapes may be used with equal accuracy. In an embodiment which uses such structures, the coils are rigidly coupled to the magnetic resonance scanner and are preferably built into the magnetic resonance scanner's magnet assembly. By providing external magnetic field generating elements a complete position and orientation tracking system may be constructed independent of a magnetic resonance scanner through the above described techniques.

Figs. 4A-D show examples of magnetic field sensing coils. Fig. 4A shows a single solenoid coil, Fig. 4B shows three ring coils with their axes orthogonal to one another and Fig. 4C is three adjacent rectangular coils with their axes orthogonal to one another. Fig. 4D shows three co-located coils with their axes orthogonal to one another. The solenoid coil is preferred when only five degrees of freedom of an object is sought. The three ring shaped coils or the three rectangular shaped coils with their axes mutually distinguishable in combination with a magnetic field source having at least two coils with their axes mutually distinguishable provides sufficient information to determine six degrees of freedom of an object. The shape of Fig. 4D provides a compact volume for three coils and additionally provides for easy manufacture. The magnetic field sensing coils of Figs. 4A-D are shown for exemplary purposes only and other shapes or types of magnetic field sensors may be used with embodiments of the invention as described, for example, Hall effect devices, flux gate devices, and Kerr-effect devices. For each magnetic field sensor, a magnetic field sensing model is necessary which describes the relationship between the output signal and the magnetic flux density.

For a magnetic field sensor, which is constructed from a single solenoid type coil, the magnetic field sensing model is computed using the Faraday's Induction Law assuming that the magnetic field is constant over the surface area of the coil. The Faraday Law defines the magnetic flux linking $\phi$ of a coil as:

$$\phi = \int_A \overline{B} \cdot \overline{n} \, da = \overline{B} \cdot \overline{n} A$$

The electromotive force E , in the coil is:

$$E = -L \frac{d\phi}{dt}$$

Where $\overline{n}$ is the normal of the coil having a surface area A, and inductance L. As described in Classical Electrodynamics by J.D. Jackson, Wiley & Sons N.Y., chapter 6, pages 209-223. A signal representative of the electromotive force which is created in response to the magnetic field for each magnetic field source element is measured for each element of the magnetic field sensor and from the electromagnetic field sensing model described above a measured magnetic field matrix may be created.

The disclosed apparatus and method may be implemented in combination of hardware and software. Representations for hardware are passive electronic components for example resistors capacitors, inductors, coils and active electronic components such as a transistor or more complex integrated circuits of analog and digital nature, such as operational amplifiers or logic circuits. Implementation of the method requires execution of computer instructions or operations. Fixed or re-programmable devices may be employed such as different types of ROM (Read Only Memory), RAM (Random Access Memory), or FPGAs (Field Programmable Gate Arrays), CPLDs (Complex Programmable Logic Devices) or microprocessors. These offer alternatives for implementation, for example trading speed of execution for implementation cost. Such implementation may include a series of computer instructions fixed either on a tangible medium, such as a computer readable media (*e.g.*, a diskette, CD-ROM, ROM, or fixed disk) or transmittable to a computer system, via a communications adapter connected to a network over a medium, such as Ethernet or modem or other interface device. Medium may be either a tangible medium (*e.g.*, wire or optical communication lines) or a medium implemented with wireless techniques (*e.g.*, depend on the frequency, RF, microwave or light or other transmission techniques). The series of computer instructions embodies all or part of the functionality previously described herein with respect to the system. Those skilled in the art should appreciate that such computer instructions can be written in a number of programming languages for use with many computer architectures or operating systems. Furthermore, such instructions may be stored in any memory device, such as semiconductor, magnetic, optical or other memory devices, and may be transmitted using any communications technology, such as optical, infrared, microwave, or other transmission technologies. It is expected that such a computer program product may be distributed as a removable media with accompanying printed or electronic documentation (*e.g.*, shrink wrapped software), preloaded with a computer system (*e.g.*, on system ROM or fixed disk), or distributed from a server or electronic bulletin board over the network (*e.g.*, the Internet or World Wide Web).

Although various exemplary embodiments of the invention have been disclosed, it should be apparent to those skilled in the art that various changes and modifications can be made which will achieve some of the advantages of the invention without departing from the true scope of the invention. These and other obvious modifications are intended to be covered by the appended claims.

## Claims

1. An electromagnetic position and orientation tracking system to determine an object position and orientation within a magnetic resonance scanner having:

   a magnetic field source (210);
   a magnetic field sensor (220); and
   a processor having
   a magnetic field generation model (254) of the magnetic field source (210);
   a magnetic field sensing model (255) of the magnetic field sensor (220);
   the processor being arranged:

   to generate an electric current by an electric current generator (215) through the magnetic field source (210);
   to obtain a signal from the magnetic field sensor (220) in response and proportional to the magnetic field (205) of the magnetic field source (210);
to build an estimated magnetic field matrix (256) based on the magnetic field generation model, a position and orientation estimate (258) of the magnetic field sensor and the electric current of the electric current generator;
to build a measured magnetic field matrix (257) based on the magnetic field sensing model (255) and the signal from the magnetic field sensor;
to compute an error value between the measured and the estimated magnetic field matrices (256, 257);
to modify the position and orientation estimate until the error value is below a given threshold; and
to output the position and orientation estimate;

wherein the magnetic field generation model (254) includes description of elements which are not directly driven by the electric current generator, but are magnetically coupled.

2. An electromagnetic position and orientation tracking system according to claim 1 wherein the magnetic field source (210) is in the form of a tetrahedron.

## System for Magnetic Resonance with Position and Orientation Tracking

Static Magnetic Field
Generating Assembly 130

Radio Frequency Coil
Assembly 150

Magnetic Field Gradient
Coil Assembly 140

Second
Magnetic Field
Sensor 170

Magnetic Field
Source 110

Y

Z

X

Magnet Assembly of
Magnetic Resonance
Scanner
105

Reference
Coordinate
System

Pointer 160

Magnetic Field Sensor 120

Subject 180

Fig. 1A.

## Block Diagram of a System for Magnetic Resonance with Position and Orientation Tracking

| Magnetic Field Source 110 | Magnetic Field Sensor 120 | Static Magnetic Field Generating Assembly 130 | Magnetic Field Gradient Coil Assembly 140 | Radio Frequency Coil Assembly 150 |

processor for position and orientation tracking
192

processor for magnetic resonance data acquisition
190

system processor
195

| user input 196 | user output 197 | data archive 198 |

Magnetic Resonance Scanner with Position and Orientation Tracking Device 100

Fig. 1B.

POSITION AND ORIENTATION TRACKING DEVICE

MAGNETIC FIELD SOURCE 210          MAGNETIC FIELD SENSOR 220

PROCESSOR FOR POSITION AND
ORIENTATION TRACKING 292

POSITION AND ORIENTATION
TRACKING DEVICE 200

FIG. 2A

FUNCTIONAL BLOCK DIAGRAM OF POSITION AND ORIENTATION TRACKING DEVICE

MAGNETIC FIELD
SOURCE
210

MAGNETIC FIELD
205

MAGNETIC FIELD
SENSOR
220

ELECTRIC CURRENT
GENERATOR
215

MAGNETIC FIELD
SOURCE SIGNAL
CONVERTER 232

MAGNETIC FIELD
SENSOR SIGNAL
CONVERTER 234

MAGNETIC FIELD
SOURCE SIGNAL
CORRELATOR 236

MAGNETIC FIELD
SENSOR SIGNAL
CORRELATOR 238

MODEL FOR
MAGNETIC FIELD
GENERATION
254

ESTIMATED
MAGNETIC FIELD
MATRIX
256

MEASURED
MAGNETIC FIELD
MATRIX
257

MODEL FOR
MAGNETIC FIELD
SENSING
255

MAGNETIC FIELD
SOURCE MODEL
INPUT
PARAMETERS
252

MAGNETIC FIELD
MATRIX
COMPARATOR
251

MAGNETIC FIELD
SENSING MODEL
INPUT
PARAMETERS
253

LOCATION
ESTIMATOR 258

LOCATION OUTPUT
259

FIG. 2B

EXAMPLES OF COIL SHAPES AND LINE SEGMENT MODELS
FOR MAGNETIC FIELD GENERATION

FIG. 3A

FIG. 3B

FIG. 3C

FIG. 3D

FIG. 3E

FIG. 3F

FIG. 3G

FIG. 3H

EXAMPLES OF MAGNETIC FIELD SENSORS

FIG. 4A

FIG. 4B

FIG. 4C

FIG. 4D

EP 1 873 545 A2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 4737794 A
- US 4849692 A
- US 5558091 A
- US 5600330 A
- US 5617857 A
- US 5622170 A
- US 5828770 A
- WO 9605768 A
- US 5211165 A
- US 5787886 A
- US 5752513 A
- US 5592939 A
- US 5307808 A
- US 5353795 A
- US 5715822 A
- EP 512345 A

### Non-patent literature cited in the description

- **X. MA.** *Proc. of the ISMRM,* 1998, 688
- **J. ANDREW DERBYSHIRE.** *JMRI,* 1998, vol. 8, 924-932
- **C.P. SLICHTER.** Principles of Magnetic Resonance. Springler-Verlag
- **ZANG-HEE CHO.** Foundations of Medical Imaging. Wiley & Sons, 236-454
- The Electrical Engineering Handbook. CRC Press
- Signals and Systems. Prentice-Hall
- Digital Signal Processing. Prentice-Hall
- Discrete-Time Signal Processing. Prentice-Hall
- Numerical Recipes. W.H. Press
- Handbook for Digital Signal Processing. John Wiley an Sons
- Classical Electrodynamics. Wiley & Sons, 168-208
- **J.D. JACKSON.** Classical Electrodynamics. Wiley & Sons, 209-223